# FASCICULE DE BREVET EUROPEEN

(11) **EP 2 591 405 B1**
(45) Date de publication et mention de la délivrance du brevet: **28.01.2015**
(21) Numéro de dépôt: 11744043.8
(22) Date de dépôt: 04.07.2011
(51) Int. Cl.: G05D 16/20, H01L 35/28, G01F 15/06, F16K 31/02

(54) **DISPOSITIF DE DISTRIBUTION D'UN FLUIDE À MODULE THERMOÉLECTRIQUE**
FLUIDABGABEVORRICHTUNG MIT EINEM THERMOELEKTRISCHEN MODUL
FLUID DELIVERY DEVICE INCLUDING A THERMOELECTRIC MODULE

(30) Priorité: 06.07.2010 FR 1002849
(43) Date de publication de la demande: 15.05.2013
(73) Titulaire: Commissariat à l'Énergie Atomique et aux Énergies Alternatives, 75015 Paris (FR)
(72) Inventeur: GAILLARD, Frédéric, F-38500 Voiron (FR); PANTIGNY, Philippe, F-38640 Claix (FR); ROUVIERE, Emmanuelle, F-38120 Le Fontanil Cornillon (FR); SALOT, Raphaël, F-38250 Lans-en-Vercors (FR)
(74) Mandataire: Talbot, Alexandre
(86) Numéro de dépôt international: PCT/FR2011/000391
(87) Numéro de publication internationale: WO 2012/004471

(56) Documents cités:
- WO-A1-00/70313
- WO-A2-02/10695
- US-A- 3 691 408
- US-A- 4 618 091

## Description

L'invention est relative à un dispositif de distribution d'un fluide comportant un détendeur comprenant :
- une première cavité à une première pression,
- une seconde cavité à une seconde pression inférieure à la première pression,
- une cloison séparant la première cavité de la seconde cavité,
- une vanne de restriction disposée entre les première et seconde cavités.

### État de la technique

Les détendeurs sont des mécanismes permettant de faire passer un fluide d'une première cavité, où ledit fluide est à une première pression, à une seconde cavité, où le fluide se retrouve à une seconde pression inférieure à la première pression.

Des dispositifs de distribution de fluide utilisant des détendeurs existent en robinetterie : typiquement, ils se placent dans un bâtiment au niveau du compteur pour réduire la pression du réseau urbain, par exemple d'eau ou de gaz, d'environ 10bars à une pression d'environ 3bars permettant la distribution de fluide dans le réseau du bâtiment.

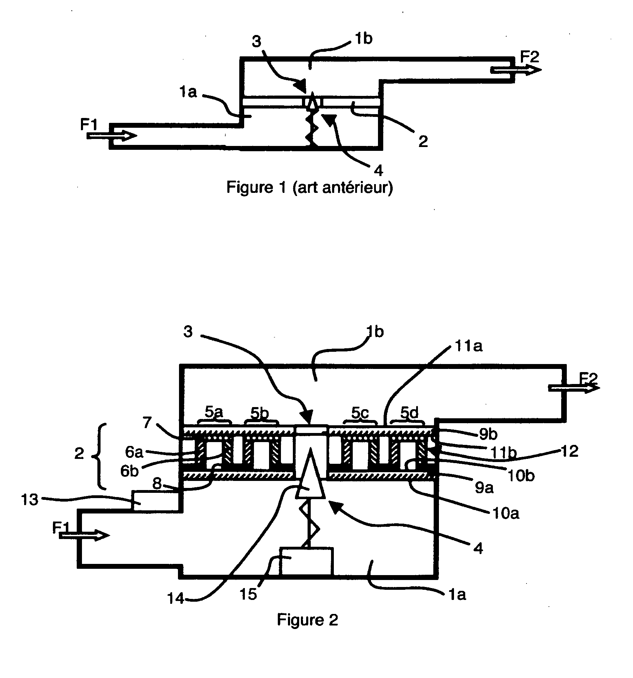

La figure 1 illustre un dispositif de distribution d'un fluide selon l'art antérieur. Un tel dispositif comporte une première cavité 1 a à une première pression, et une seconde cavité 1b à une seconde pression inférieure à la première pression. Les deux cavités sont séparées par une cloison 2. Une vanne de restriction 4 est disposée entre les première et seconde cavités 1 a, 1 b et permet le passage du fluide de la première cavité 1 a à la seconde cavité 1 b en modifiant sa pression. Le sens de circulation du fluide est représenté par les flèches F1 et F2. Les deux cavités 1 a, 1 b communiquent entre elles par un trou 3 débouchant dans lequel peut se déplacer un pointeau, formant en partie la vanne de restriction 4 et permettant de régler la pression dans le réseau en aval de la vanne de restriction 4 selon le sens de circulation du fluide, c'est-à-dire à partir de la seconde cavité 1 b.

De nos jours, les dispositifs de distribution tendent à devenir « intelligents », ils peuvent, selon les modèles, incorporer un compteur et une puce émettrice reliée au compteur, permettant à un agent de la société responsable de la facturation de la consommation de relever le compteur à distance. Ce relevé à distance peut être utile notamment lorsque l'abonné au réseau de distribution n'est pas présent à son domicile, et que le compteur n'est pas directement accessible à l'agent. De tels compteurs intelligents sont alimentés par des piles, par exemple de type bouton, ils présentent alors un inconvénient majeur au niveau de l'alimentation de la puce émettrice lorsque la pile est vide.

Le document WO 00/70313 décrit un dispositif de régulation de gaz qui comporte une région à haute pression disposée entre une entrée et un régulateur, et une région à basse pression en aval du régulateur. Le régulateur permet de réduire la pression de distribution du gaz. Dans un mode de réalisation, un module thermoélectrique peut produire une tension en utilisant le changement de température provoqué par le régulateur.

Le document US 4,618,091 divulgue un dispositif de régulation du passage d'au moins un liquide qui est muni d'un module thermoélectrique.

Dans le cas d'un unique liquide, une face du module thermoélectrique est en contact avec le tuyau dans lequel le liquide circule alors que l'autre face du module comporte des ailerons de refroidissement exposés à l'air ambiant.

Dans le cas de deux liquides, le module thermoélectrique est en contact avec les deux liquides pour exploiter le gradient de température.

Le document US 3,691,408 décrit un dispositif de génération d'énergie par effet thermoélectrique. Le dispositif utilise un tube vortex pour séparer des fractions chaudes et froides d'un élément gazeux. Une fois séparées les fractions transitent respectivement dans deux cavités séparées par un module thermoélectrique.

Le document WO 02/10695 décrit un compteur à gaz utilisant un module convertissant l'énergie chimique en énergie électrique à partir d'une fraction du gaz. Le module comporte une source de chaleur et un module thermoélectrique.

### Objet de l'invention

L'objet de l'invention consiste à réaliser un dispositif de distribution de fluide ne présentant pas les inconvénients de l'art antérieur.

On tend vers ce but par les revendications annexées et plus particulièrement en ce que la cloison comporte un module thermoélectrique ayant un côté chaud en contact thermique avec la première cavité et un côté froid en contact thermique avec la seconde cavité.

Selon un mode de réalisation, le module thermoélectrique est relié à un élément de stockage d'énergie de sorte à permettre sa recharge.

Selon un développement, la vanne de restriction est à réglage électrique, et est alimentée par l'élément de stockage d'énergie.

Selon un autre mode de réalisation, le dispositif peut comporter un compteur apte à mesurer la consommation en fluide. Le dispositif peut en outre comporter des moyens de transmission des mesures de consommation électriquement alimentés par le module thermoélectrique ou par l'élément de stockage d'énergie.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
la figure 1 représente un dispositif de distribution de fluide selon l'art antérieur.
La figure 2 illustre un dispositif de distribution de fluide selon un mode de réalisation de l'invention.
La figure 3 illustre un schéma-bloc des fonctionnalités possibles du dispositif de distribution de fluide.

### Description de modes de réalisation préférentiels

Contrairement aux dispositifs de distribution selon l'art antérieur, le dispositif et ses variantes décrites ci-après permet de générer lui-même son propre courant en utilisant l'effet Seebeck.

Comme illustré à la figure 2, le dispositif de distribution d'un fluide comporte un détendeur qui comprend une première cavité 1 a à une première pression, une seconde cavité 1 b à une seconde pression inférieure à la première pression, et une cloison 2 séparant la première cavité 1 a de la seconde cavité 1 b. Le dispositif comporte en outre une vanne de restriction 4 disposée entre la première cavité 1 a et la seconde cavité 1 b. Le fluide est à une première pression dans la première cavité 1 a, et à une seconde pression dans la seconde cavité 1 b. C'est la vanne de restriction 4 qui permet le passage du fluide de la première cavité 1 a à la seconde cavité 1 b, tout en générant la différence de pression, évoquée ci-dessus, entre les deux cavités 1 a, 1 b, et donc une différence de température. Sur la figure 2, le sens d'écoulement du fluide est représenté par les flèches F1 et F2. En fait, quand le détendeur ne fonctionne pas, c'est-à-dire qu'aucun fluide ne traverse le dispositif, il y a équilibre de température entre les cavités 1 a, 1 b. Lorsque le fluide traverse le dispositif, sa détente entre la première cavité 1 a et la seconde cavité 1 b génère une différence de pression au niveau des cavités de part et d'autre de la cloison 2, et donc un gradient de température de part et d'autre de la cloison 2.

La cloison 2 comporte un module thermoélectrique 12 ayant un côté chaud en contact thermique avec la première cavité 1a, et un côté froid en contact thermique avec la seconde cavité 1 b. Ce module thermoélectrique 12 permet d'exploiter le gradient thermique pour générer du courant notamment lorsque le fluide traverse le dispositif. De préférence, la vanne de restriction est agencée de sorte à permettre au fluide de traverser la cloison 2 au niveau du module thermoélectrique 12, c'est-à-dire que l'on peut considérer que le fluide traverse le module thermoélectrique 12.

En fait, le module thermoélectrique 12 comporte des thermocouples 5a, 5b, 5c, 5d, reliés en série électriquement et en parallèle thermiquement. Chaque thermocouple est en contact thermique d'une part avec la première cavité 1 a et d'autre part avec la seconde cavité 1 b.

Un thermocouple 5a peut comporter deux plots 6a, 6b reliés électriquement entre eux à l'une de leurs extrémités par exemple par un élément de connexion électrique 7. Les plots 6a, 6b sont généralement formés dans deux matériaux ou alliages thermoélectriques distincts. À titre d'exemple, les matériaux utilisés pour former les plots peuvent être des semi-conducteurs (MgSiGeSn, SiGe, Bi₂Te₃, etc.) ou des semi-métaux comme les oxydes intermétalliques (LiNaCoO₂, NaCoO₂, HgCoO₂, etc.)

Les thermocouples sont agencés de sorte à exploiter le gradient de température entre les deux cavités 1 a, 1 b pour générer du courant. Sur la figure 2, le dispositif comporte quatre thermocouples 5a, 5b, 5c, 5d. Afin, d'optimiser le rendement du module thermoélectrique, les thermocouples 5a, 5b, 5c, 5d sont, de préférence, reliés électriquement entre eux en série au niveau de la source chaude (première cavité 1 a sur la figure 2), par des éléments de liaison 8. Dans l'exemple particulier de la figure 2, les thermocouples ont chacun leur élément de connexion électrique 7 en contact thermique avec la seconde cavité 1 b (qui forme alors la source froide). Bien entendu le module thermoélectrique peut être retourné, c'est-à-dire que les thermocouples peuvent avoir leurs éléments de connexion électrique 7 en contact thermique avec la première cavité 1a, et les éléments de liaison 8 entre les thermocouples peuvent être en contact thermique avec la seconde cavité 1 b, l'essentiel étant de pouvoir exploiter le gradient de température entre les deux cavités lors de la détente du fluide.

Les éléments de connexion électrique 7 et les éléments de liaison 8 peuvent être constitués par des métaux thermiquement conducteurs, et dont le coefficient Seebeck est nul ou quasi-nul, comme par exemple de l'or.

Par contact thermique, on entend que la température du fluide dans la première cavité 1 a est transmise au côté chaud du module thermoélectrique 12, et que la température du fluide dans seconde cavité 1 b est transmise au côté froid du module thermoélectrique 12.

Sur l'exemple particulier de la figure 2, la cloison 2 est formée par deux plaques 9a, 9b prenant en sandwich le module thermoélectrique. Les plots 6a, 6b des thermocouples 5a, 5b, 5c, 5d sont, de préférence, perpendiculaires aux deux plaques 9a, 9b qui sont, de préférence, parallèles entre elles. La première plaque 9a comporte une première paroi 10a délimitant en partie la première cavité 1 a, et une seconde paroi 10b en contact avec les éléments de liaison 8. Bien entendu, la seconde paroi 10b est soit électriquement isolante, soit isolée électriquement des éléments de liaison 8 par interposition d'un matériau électriquement isolant. La seconde plaque 9b comporte une première face 11a délimitant en partie la seconde cavité 1 b, et une seconde face 11 b en contact avec les éléments de connexion 7 des thermocouples. Bien entendu, la seconde face 11 b est soit électriquement isolante, soit isolée électriquement des éléments de connexion 7 par interposition d'un matériau électriquement isolant. Les première et seconde plaques 9a, 9b peuvent être formées dans un matériau ou un alliage de matériaux fortement conducteur de la température pour améliorer la réactivité du dispositif. Ceci permet la transmission rapide de la température du fluide de la première cavité 1 a au côté chaud du module thermoélectrique 12, et la température du fluide de la seconde cavité 1 b au côté froid du module thermoélectrique 12. Dans le cas où le fluide traverse constamment le dispositif, le matériau des première et seconde plaques 9a, 9b est sans importance, car en fonctionnement continu on obtient un équilibre du gradient de température entre les cavités, et la conductivité thermique au niveau des plaques 9a, 9b n'intervient plus.

Selon le mode de réalisation illustré à la figure 2, les plots 6a, 6b des thermocouples sont séparés par de l'air jouant un rôle d'isolant thermique pour conserver le meilleur gradient de température entre la source chaude et la source froide. Ceci implique que la cloison 2 comporte un espace interne fermé et étanche, dans lequel sont formés les thermocouples 5a, 5b, 5c, 5d. De préférence, l'espace interne est à vide partiel, par exemple de 10⁻⁵ bars pour améliorer l'isolation thermique. Selon une variante, l'espace interne est comblé par un aérogel de silicium présentant des propriétés d'isolation thermique élevées comme par exemple un aérogel à base de SiO₂.

L'agencement particulier décrit ci-dessus du module thermoélectrique 12 n'est qu'un exemple de réalisation. Bien entendu, l'homme du métier sera capable d'adapter tout module thermoélectrique permettant d'exploiter le gradient de température entre la première et la seconde cavité 1a, 1b. Par exemple, la cloison 2 peut être une plaque massive dans laquelle le module thermoélectrique est formé. Le matériau de la plaque massive est alors thermiquement et électriquement isolant, les thermocouples sont formés par remplissages d'évidements réalisés dans la plaque massive avant formation des éléments de liaison et de connexion.

Selon un autre exemple de réalisation, la cloison est formée par assemblage de barreaux frittés en matériaux thermoélectriques reliés électriquement par des éléments de liaison et de connexion de sorte à former une série de thermocouples tels que décrits ci-dessus. Ensuite, deux plaques viennent prendre en sandwich cet assemblage, les plaques étant isolées électriquement au préalable au moins au niveau des éléments de connexion et de liaison.

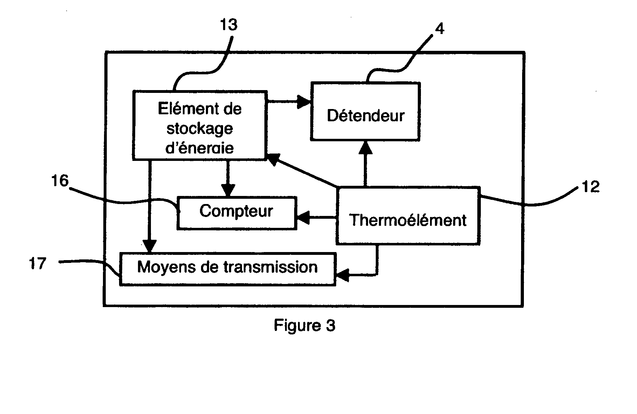

Selon un mode de réalisation illustré aux figures 2 et 3, le module thermoélectrique 12 est relié à un élément de stockage d'énergie 13 de sorte à permettre la recharge dudit élément de stockage d'énergie (par exemple une batterie ou un accumulateur). Ainsi, lorsque le fluide circule au travers du dispositif de distribution, l'énergie générée par le module thermoélectrique 12 peut être stockée dans l'élément de stockage dans la perspective d'une utilisation future. Si le dispositif ne comporte pas d'élément de stockage d'énergie 13, le courant généré peut être injecté dans un réseau électrique.

Selon un développement, la vanne de restriction 4 est à réglage électrique, et est alimentée par exemple en courant par l'élément de stockage d'énergie 13. Par réglage électrique, on entend qu'il est possible de piloter la vanne de restriction 4 pour modifier la différence de pression entre la première cavité 1 a et la seconde cavité 1 b. Un tel réglage permet, par exemple, au dispositif de distribution de s'autoréguler en cas de perte de charge dans le réseau de distribution. En effet, il peut être nécessaire d'ajuster les différences de pression, ou même d'asservir les différences de pression en fonction des installations en aval. À titre d'exemple, on peut citer les différences dans les tailles des tuyaux en aval et en amont du dispositif, ou des installations demandant des pressions différentes en cours d'utilisation.

Selon une variante, la vanne de restriction 4 à réglage électrique peut aussi être alimentée, par exemple en courant, directement par le module thermoélectrique 12. Dans ce cas particulier, le réglage n'est possible que lorsque le fluide traverse le dispositif.

Comme sur la figure 2, la vanne de restriction 4 à réglage électrique peut être formée par un pointeau 14 apte à se déplacer de sorte à plus ou moins obstruer un trou 3 pratiqué dans la cloison 2, et reliant la première cavité 1a à la seconde cavité 1 b. La mise en translation du pointeau 14 peut alors être réalisée par un moteur 15 constituant en partie la vanne 4. Ce moteur 15 peut être alimenté électriquement par l'élément de stockage d'énergie 13, ou directement par le module thermoélectrique 12. Le moteur 15 peut être asservi par une carte électronique et au moins un capteur de pression disposé en aval (non représentés) de la vanne 4 selon le sens d'écoulement du fluide. Le capteur disposé en aval permet de contrôler la pression distribuée, le gradient de température et, le cas échéant, d'adapter la position du pointeau 14 pour maintenir une pression constante dans le réseau de distribution en aval du dispositif de distribution. Bien entendu, en combinaison avec le mode de réalisation où la cloison comporte deux plaques 9a, 9b, le trou 3 est réalisé de manière à ne pas compromettre l'étanchéité de l'espace interne de la cloison 2.

Selon un autre développement, le dispositif peut comporter, comme sur la figure 3, un compteur 16 apte à mesurer la consommation en fluide. La consommation en fluide est représentative de la quantité de fluide passant de la première cavité 1a à la seconde cavité 1 b. Ce compteur 16 peut être de type mécanique ou de type électronique. Le compteur peut aussi comporter un afficheur de la consommation, cet afficheur peut être de type mécanique ou de type LCD. Dans le cas où l'afficheur est de type LCD et/ou le compteur de type électronique, ce dernier peut être alimenté par l'élément de stockage d'énergie 13, ou directement par le module thermoélectrique 12. Sur la figure 3, le départ de chaque flèche indique une source de courant, et l'arrivée de la flèche indique l'élément recevant le courant.

Comme indiqué précédemment dans l'art antérieur, il peut être intéressant de pouvoir relever facilement la consommation en fluide. Le dispositif peut comporter des moyens de transmission 17 des mesures de consommation enregistrées par le compteur, ces moyens permettent aux compagnies de distribution de fluide de faire des relevés même dans des situations où le compteur n'est pas accessible. Les moyens de transmission 17 peuvent être électriquement alimentés par le module thermoélectrique 12, ou par l'élément de stockage d'énergie 13. Bien entendu, si les moyens de transmission 17 sont directement alimentés par le module thermoélectrique 12, ces derniers ne peuvent émettre que si le fluide traverse le dispositif de distribution, ou si un gradient de température suffisant est toujours présent entre les deux cavités pour générer un courant suffisant.

Les moyens de transmission 17 des mesures peuvent comporter une antenne (non représentée) d'émission des données représentatives de la consommation en fluide. Ces données peuvent être transmises en continu, par exemple avec un identifiant du dispositif de distribution associé. Les moyens de transmission 17 peuvent aussi comporter une antenne de réception (non représentée), les données étant alors transmises uniquement à réception d'une requête par les moyens de transmission 17. La variante avec transmission après réception d'une requête permet de limiter la consommation en énergie du dispositif de distribution, les moyens de transmission 17 se trouvant dans un état de veille tant qu'une requête n'est pas réceptionnée.

Ainsi, l'utilisation de la thermoélectricité dans le dispositif de distribution de fluide permet de doter ce dernier de nouvelles fonctions comme l'affichage, les communications, l'automatisation, etc., tout en évitant la dépendance du dispositif aux sources de courant extérieures.

Le fluide peut être de l'eau, du gaz, ou tout type de corps liquide ou gazeux. Dans le cadre d'une utilisation pour la distribution de l'eau au niveau d'une habitation, la différence de pression entre l'eau du réseau de distribution de ville à 10bars et l'eau dans les canalisations privées de l'habitation à 3bars permet d'obtenir environ 10°C de différence entre les deux cavités. Une telle différence de température permet en fonction du nombre et de l'arrangement des thermocouples de générer une tension entre 10mV et 100mV associée à une intensité comprise entre 1µA et 10µA. Par exemple, en plaçant dix thermocouples en Bi₂Te₃ répartis sur un support de 10cm*10cm, il est possible d'obtenir 200µV/K (K représentant les degrés Kelvin) avec un gradient de température de 15°C.

Ce dispositif peut être installé dans tout type d'installation de distribution de fluide où il est nécessaire de diminuer la pression. Les première et seconde cavités peuvent alors être reliées respectivement à un tuyau d'arrivée du fluide et un tuyau de sortie du fluide.

Ce dispositif peut être traversé par un unique fluide, ce fluide étant à une première pression dans la première cavité et à une seconde pression dans la seconde cavité.

## Revendications

1. Dispositif de distribution d'un fluide comportant un détendeur comprenant :
- une première cavité (1 a) à une première pression,
- une seconde cavité (1b) à une seconde pression inférieure à la première pression,
- une cloison (2) séparant la première cavité (1a) de la seconde cavité (1b),
- une vanne de restriction (4) disposée entre les première et seconde cavités (1 a, 1 b),
dispositif **caractérisé en ce que** la cloison (2) comporte un module thermoélectrique (12) ayant un côté chaud en contact thermique avec la première cavité (1 a), et un côté froid en contact thermique avec la seconde cavité (1 b).

2. Dispositif selon la revendication 1, **caractérisé en ce que** le module thermoélectrique (12) est relié à un élément de stockage d'énergie (13) de sorte à permettre sa recharge.

3. Dispositif selon la revendication 2 **caractérisé en ce que** la vanne de restriction (4) est à réglage électrique, et est alimentée par l'élément de stockage d'énergie (13).

4. Dispositif selon l'une quelconque des revendications 1 à 3, **caractérisé en ce qu'**il comporte un compteur (16) apte à mesurer la consommation en fluide.

5. Dispositif selon la revendication 4, **caractérisé en ce qu'**il comporte des moyens de transmission (17) des mesures de consommation électriquement alimentés par le module thermoélectrique (12).

6. Dispositif selon la revendication 4, **caractérisé en ce qu'**il comporte des moyens de transmission (17) des mesures de consommation électriquement alimentés par l'élément de stockage d'énergie (13).

7. Dispositif selon la revendication 1, **caractérisé en ce que** la vanne de restriction (4) est agencée de sorte à permettre au fluide de traverser la cloison (2) au niveau du module thermoélectrique (12).

## Patentansprüche

1. Vorrichtung zur Abgabe eines Fluids, mit einem Druckminderer, umfassend:
- einen ersten Hohlraum (1a) mit einem ersten Druck,
- einen zweiten Hohlraum (1b) mit einem zweiten Druck, der niedriger als der erste Druck ist,
- eine Trennwand (2), die den ersten Hohlraum (1a) von dem zweiten Hohlraum (1b) trennt,
- ein Drosselventil (4), das zwischen dem ersten und dem zweiten Hohlraum (1a, 1b) angeordnet ist,
Vorrichtung, **dadurch gekennzeichnet, dass** die Trennwand (2) ein thermoelektrisches Modul (12) umfasst, das eine mit dem ersten Hohlraum (1a) in Wärmekontakt befindliche heiße Seite und eine mit dem zweiten Hohlraum (1b) in Wärmekontakt befindliche kalte Seite aufweist.

2. Vorrichtung nach Anspruch 1, dadurch gekennzeichet, dass das thermoelektrische Modul (12) mit einem Energiespeicherungselement (13) verbunden ist, um sein Wiederaufladen zu ermöglichen.

3. Vorrichtung nach Anspruch 2, **dadurch gekennzeichnet, dass** das Drosselventil (4) elektrisch regelbar ist und durch das Energiespeicherungselement (13) versorgt wird.

4. Vorrichtung nach einem der Ansprüche 1 bis 3, **dadurch gekennzeichnet, dass** sie einen Zähler (16) umfasst, der geeignet ist, den Fluidverbrauch zu messen.

5. Vorrichtung nach Anspruch 4, **dadurch gekennzeichnet, dass** sie Mittel zur Übertragung (17) der Verbrauchsmessungen umfasst, die durch das thermoelektrische Modul (12) elektrisch versorgt werden.

6. Vorrichtung nach Anspruch 4, **dadurch gekennzeichnet, dass** sie Mittel zur Übertragung (17) der Verbrauchsmessungen umfasst, die durch das Energiespeicherungselement (13) elektrisch versorgt werden.

7. Vorrichtung nach Anspruch 1, **dadurch gekennzeichnet, dass** das Drosselventil (4) angeordnet ist, um dem Fluid zu ermöglichen, die Trennwand (2) im Bereich des thermoelektrischen Moduls (12) zu durchqueren.

## Claims

1. A fluid distribution device comprising a pressure reducer comprising:
- a first cavity (1a) at a first pressure,
- a second cavity (1b) at a second pressure lower than the first pressure,
- a partition (2) separating the first cavity (1a) from the second cavity (1b),
- a restricting valve (4) arranged between the first and second cavities (1a, 1b),
a device **characterized in that** the partition (2) comprises a thermoelectric module (12) having a hot side in thermal contact with the first cavity (1a) and a cold side in thermal contact with the second cavity (1 b).

2. The device according to claim 1, **characterized in that** the thermoelectric module (12) is connected to an energy storage element (13) so as to enable it to be recharged.

3. The device according to claim 2 **characterized in that** the restricting valve (4) is provided with electric adjustment means and is supplied by the energy storage element (13).

4. The device according to any one of claims 1 to 3, **characterized in that** it comprises a meter (16) designed to measure the fluid consumption.

5. The device according to claim 4, **characterized in that** it comprises transmission means (17) of the consumption measurements electrically supplied by the thermoelectric module (12).

6. The device according to claim 4, **characterized in that** it comprises transmission means (17) of the consumption measurements electrically supplied by the energy storage element (13).

7. The device according to claim 1, **characterized in that** the restricting valve (4) is arranged so as to enable the fluid to flow through the partition (2) at the level of the thermoelectric module (12).
